## Europäisches Patentamt

## European Patent Office

## Office européen des brevets

(19)

(11) Numéro de publication: **0 158 550 B1**

(12) **FASCICULE DE BREVET EUROPEEN**

(45) Date de publication du fascicule du brevet:
**19.11.87**

(21) Numéro de dépôt: **85400473.6**

(22) Date de dépôt: **12.03.85**

(51) Int. Cl.⁴: **H 01 L 23/56, H 01 L 23/48**

(54) Dispositif semiconducteur hyperfréquence à connexions externes prises au moyen de poutres.

(30) Priorité: **16.03.84 FR 8404103**

(43) Date de publication de la demande:
**16.10.85 Bulletin 85/42**

(45) Mention de la délivrance du brevet:
**19.11.87 Bulletin 87/47**

(84) Etats contractants désignés:
**DE GB NL**

(56) Documents cités:
**EP - A - 0 081 423**
**US - A - 4 340 975**

**PATENTS ABSTRACTS OF JAPAN, vol. 7, no. 99
(E-172)(1244), 27 avril 1983**
**PATENTS ABSTRACTS OF JAPAN, vol. 5, no. 171
(E-80)(843), 30 octobre 1981**
**9th EUROPEAN MICROWAVE CONFERENCE, 17-20
septembre 1979, Brighton, GB, pages 576-579; Y.
ARCHAMBAULT: "The distributed oscillator : a solution
for power GaAs IMPATT combining"**

(73) Titulaire: **THOMSON-CSF, 173, Boulevard Haussmann,
F-75379 Paris Cédex 08 (FR)**

(72) Inventeur: **Funck, Ronald, THOMSON-CSF SCPI 173, bld
Haussmann, F-75379 Paris Cedex 08 (FR)**
Inventeur: **Henry, Raymond, THOMSON-CSF
SCPI 173, bld Haussmann, F-75379 Paris Cedex 08 (FR)**

(74) Mandataire: **Taboureau, James et al, THOMSON-CSF
SCPI 19, avenue de Messine, F-75008 Paris (FR)**

## Description

La présente invention concerne un dispositif semiconducteur hyperfréquence travaillant dans le doaine millimétrique,notamment à des fréquences gales ou supérieures à 30 GHz, du type de ceux dont les connexions externes sont prises au moyen de poutres métalliques à plat, plus connues sous la terminologie anglosaxonne «beam-lead».

Sans que cela constitue une limitation de l'invention, celle-ci sera exposée en s'appuyant sur le cas d'une diode, la diode étant à la base de tout composant semiconducteur plus complexe, tel que le transistor par exemple.

On connaît déjà une structure de diode hyperfréquence, telle que par example une diode PIN à structure verticale, travaillant à fréquence élevée et munie de connexions extérieures constituées par des poutres métalliques fixées à plat sur la pastille semiconductrice selon la technologie dite «beam-lead». Cette diode PIN, utilisée principalement comme diode de commutation montée en shunt ou en série dans une ligne de transmission, est par exemple réalisée à partir d'un substrat semiconducteur dopé de type N$^+$ sur lequel sont formées par épitaxie deux couches superposées dont l'une dite I est en matériau de la plus haute résistivité possible et dont l'autre est de type ·P$^+$. Une attaque chimique est effectuée à partir des couches épitaxiées jusque dans le substrat sur une profondeur donnée afin de créer un berceau de pourtour extérieur par exemple rectangulaire sous lequel subsiste une certaine épaisseur de substrat. Ce berceau est réalisé de manière à délimiter deux îlots semiconducteurs reliés entre eux par l'intermédiaire du substrat, dont l'un est de forme par exemple circulaire et dont l'autre est en forme par exemple de croissant, l'îlot rond étant en vis-à-vis et au centre de l'échancrure du croissant. Le berceau est rempli d'un matériau diélectrique, tel que par exemple du verre, et les couches P$^+$ et I de l'îlot en forme de croissant sont ensuite éliminées par attaque chimique. Un contact d'anode est assuré par une première poutre métallique s'appuyant sur la couche P$^+$ de l'îlot rond et sur le verre pour se terminer en porte-à-faux, tandis qu'un contact de cathode est assuré par une seconde poutre métallique s'appuyant sur le substrat N$^+$ en épousant sa forme en croissant pour réaliser un contact ohmique et sur le verre pour se terminer en porte-à-faux.

Un dispositif semiconducteur hyperfréquence ayant des caractéristiques selon la première partie de la revendication 1 est connu du document EP-A-0081423.

D'autre part, pour pouvoir utiliser cette diode montée en shunt dans un circuit de commutation à large bande, il est connu de rechercher d'une part une impédance nulle ou quasi nulle de la diode en polarisation directe pour l'obtention d'une isolation élevée et d'autre part une faible capacité en polarisation inverse pour permettre l'adaptation d'impédance de la diode à celle du circuit hyperfréquence environnant; de même pour un montage série de la diode dans le circuit de commutation avec une recherche d'une impédance quasi nulle en polarisation inverse et d'une faible capacité en polarisation directe de la diode.

Or, comme cela est bien connu, à la fréquence de travail de la diode, les poutres métalliques introduisent une inductance parasite en série avec la diode, que celle-ci soit polarisée en direct ou en inverse. Et, à haute fréquence, c'est-à-dire à partir de l'ordre de 30 GHz, l'impédance de cette inductance prend une valeur de plus en plus forte, de l'ordre de 25 à 50 ohms à 94 Ghzt par example, et donc augmente considérablement l'impédance de la diode, ce qui est contraire au but recherché. Cette inductance est donc gênante aux fréquences de travail élevées et sa présence rend inutilisable la diode de commutation, cette denière ne remplissant plus sa fonction d'isolation des signaux hyperfréquence. En consequénce, il s'avère nécessaire aux hautes fréquences de compenser l'inductance série de la diode.

Ce problème technique lié à une inductance trop forte des poutres métalliques aux hautes fréquences se pose également pour une diode Schottky «beamlaed», de même structure que la diode PIN décrite ci-dessus avec une jonction métal-semiconducteur, et utilisée principalement comme diode de détection et de mélange, d'où la nécessité de compenser cette inductance.

La présente invention a pour but de perfectionner ce type de diode hyperfréquence décrit précédemment et travaillant dans le domaine millimétrique en associant à la diode un élément permettant d'annuler l'inductance des poutres ou tout au moins de s'en approcher le plus près possible.

A cet effet, l'idée mère de l'invention est de réaliser une capacité en série avec l'inductance et qui est intégrée dans l'une ou les deux poutres de la diode, cette capacité étant choisie de manière à obtenir une résonance série avec l'inductance des poutres à la fréquence de travail. Ainsi, selon l'invention, la compensation de l'inductance par la capacitée est effectuée sur le composant même.

L'invention a donc pour object un dispositif semiconducteur hyperfréquence comportant une pastille semiconductrice sur laquelle sont fixées à plat au moins deux connexions externes prises au moyen de poutres métalliques, la pastille semiconductrice comprenant au moins deux couches supportées par un substrat, et un bercau rempli d'un matériau diélectrique formant un cadre qui entoure la pastille semiconductrice, et sur lequel s'appuient à plat les poutres métalliques qui se terminent en porte-à-faux, les poutres introduisant une inductance parasite à là fréquence de travail en série avec la pastille semiconductrice, caractérisé en ce qu'au moins l'une des poutres métalliques présente une fente ménagée sur toute sa largeur et sur toute son épaisseur au niveau du matériau diélectrique supportant la poutre de façon à former une capacité en série avec l'inductance par les poutres, et en ce que la fente a ses dimensions telles que la capacité formée réalise une résonance série avec l'inductance des poutres à la fréquence de travail, la capacité compensant ainsi l'inductance des poutres.

Selon une autre caractéristique, cette fente peut se présenter soit sous une forme rectiligne, soit sous une forme de ligne à méandres.

D'autres caractéristiques et avantages de l'invention apparaîtront mieux dans la description détaillée qui suit et se réfère aux dessins annexés, donnés uniquement à titre d'example et dans lesquels:

— la figure 1 représente une vue de dessus d'un mode de réalisation d'une diode PIN selon l'invention;

— la figure 2 représente une vue de dessus d'une variante d'une diode PIN selon l'invention;

— la figure 3 représente une vue en coupe selon la ligne I-I de la figure 1 ou de la figure 2;

— les figures 4a et 4b représentent les schémas équivalents de la diode selon la figure 3 en polarisation inverse et en polarisation directe;

— la figure 5 est une vue identique à la figure 3 mettant en évidence une possibilité d'ajuster la capacité;

— la figure 6 est une vue identique à la figure 3 mettant en évidence une autre possibilité d'ajuster la capacité;

— la figure 7 est une vue identique à la figure 2 avec la connexion de polarisation de la diode; et

— les figures 8a et 8b représentent les schémas équivalents de la diode selon la figure 7 en polarisation inverse et en polarisation directe.

Sur ces différentes figures, les mêmes références se rapportent aux mêmes éléments qui remplissent les mêmes fonctions en vue des mêmes résultats.

L'invention sera exposée ci-dessous en s'appuyant sur le cas d'une diode PIN au silicium à structure verticale, dotée de connexions externes beam-lead, et destinée à travailler dans le domaine millimétrique, à 94 GHz par exemple. Cette diode est principalement destinée à être utilisée en commutation en étant montée soit en shunt soit en série dans une ligne de transmission.

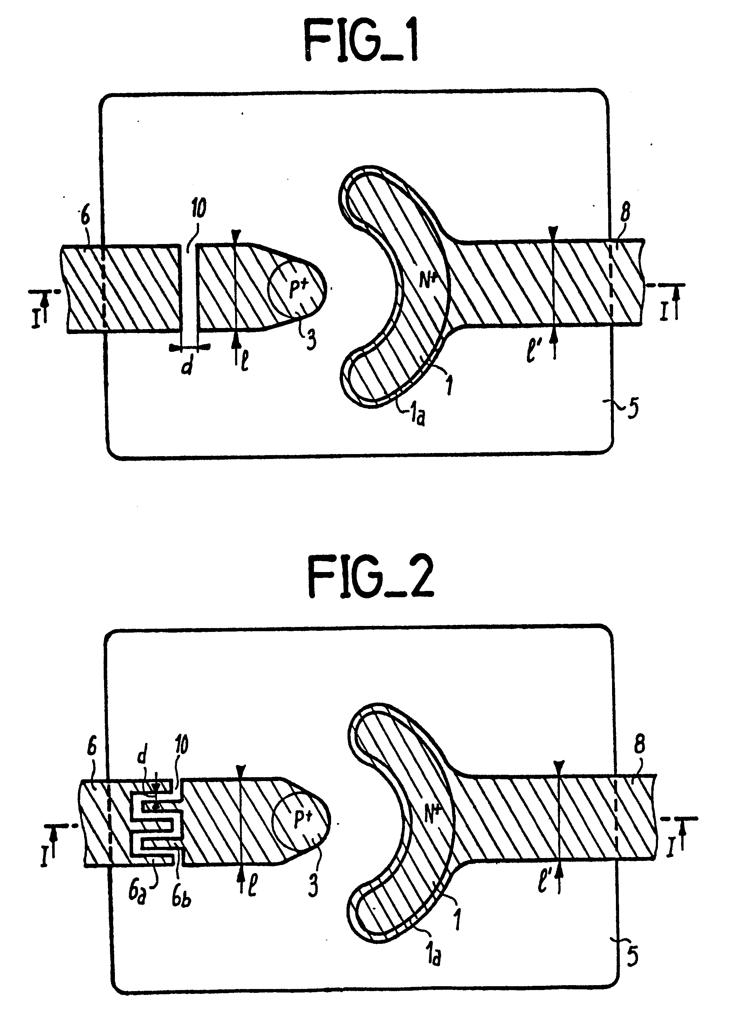

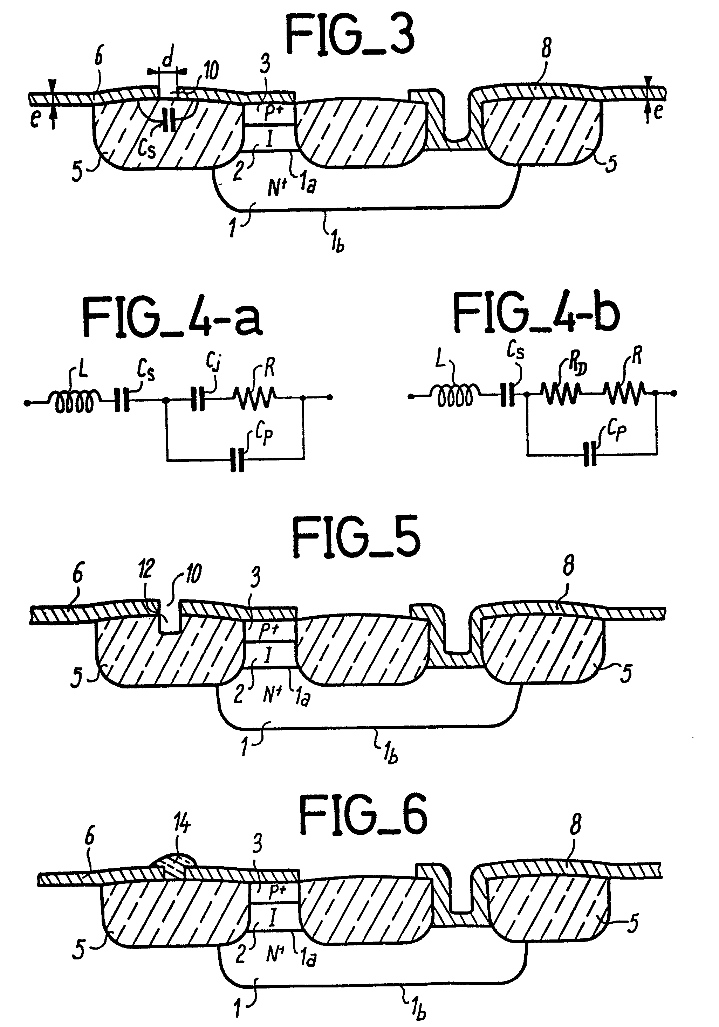

Cette diode PIN, en tant que produit final, tel que représenté en vue de dessus sur les figures 1 ou 2 et en coupe transversale sur la figure 3, comporte un substrat de silicium 1 dopé de type $N^+$ par exemple, d'épaisseur égale par exemple à 25 microns, et présentant deux faces opposées parallèles respectivement dites face avant ou supérieure 1a et face arrière ou inférieure 1b. Le substrat est recouvert partiellement en face avant de deux couches semiconductrices superposées dont l'une 2 dite I est en silicium de la plus haute résistivité possible et dont l'autre 3 est en silicium dopé de type $P^+$. L'ensemble constitué par le substrat 1 et les deux couches 2 et 3 forme donc la diode proprement dite, le substrat 1 apportant ainsi d'une part un support mécanique et d'autre part la couche contact cathode, et la couche 3 apportant la couche contact anode.

La diode est délimitée par un profond berceau 5 formant un cadre par exemple rectangulaire (figure 1 ou 2) entourant la pastille semiconductrice et s'étendant dans le substrat 1 sur une profondeur donnée, par exemple égale à 10 microns, de façon à laisser subsister ce dernier sur une certaine épaisseur, de l'ordre par exemple de 15 microns, entre sa face arrière 1b et le fond du berceau.

De plus, le berceau 5 est réalisé de façon à délimiter sous forme d'îlot, par exemple circulaire (figure 1 ou 2) ou carré, la diode proprement dite, et sous forme par exemple d'un croissant (figure 1 ou 2) la partie de la face avant non recouverte du substrat.

Comme il apparaît sur les figures 1 ou 2, l'îlot semiconducteur de forme circulaire est disposé en vis-à-vis et sensiblement au centre de l'échancrure du croissant formé par le substrat.

Le berceau 5 est rempli d'un matériau diélectrique doté de bonnes qualités mécaniques, tel que par exemple du verre fondu. Une fois comblé, le berceau de verre présente une surface légèrement bombée.

Un premier contact, ou contact d'anode, est assuré par une première poutre métallique 6, de largeur $l$ de l'ordre de 100 microns par exemple, s'appuyant à plat sur la couche $P^+$ de la diode et sur la surface du berceau de verre 5 pour se terminer en porte-à-faux. Cette poutre anode 6 beam-lead est constituée par exemple par des dépôts successifs de platine, de titane, de platine et d'or. A titre illustratif, l'épaisseur $e$ de la poutre anode 6 (figure 3) est de l'ordre de 1 micron.

Un second contact ohmique, ou contact de cathode, est assuré par une seconde poutre métallique 8 s'appuyant à plat sur la face avant 1a du substrat en épousant sa forme en croissant (figure 1 ou 2) pour y réaliser le contact ohmique et sur la surface du berceau de verre 5 pour se terminer en porte-à-faux. Comme pour la poutre anode, la poutre cathode 8 beam-lead, de largeur $l'$ et de même épaisseur $e$, est constituée par la même chaîne de dépôts successifs de platine, de titane, de platine et d'or.

Comme cela est bien connu, le schéma équivalent de la diode PIN telle qu'elle vient d'être décrite est constituée, en polarisation inverse illustrée sur la figure 4a, d'une inductance L introduite par les poutres anode et cathode, en série avec la capacité de jonction $C_j$ et la résistance de perte R introduite par le substrat, et de la capacité parasite $C_p$ entre poutres en parallèle sur $C_j$ et R. De façon similaire, en polarisation directe illustrée sur la figure 4b, l'inductance L est en série avec la résistance $R_D$ introduite par la zone dite I et la résistance de perte R, la capacité parasite $C_p$ étant en parallèle sur $R_D$ et R.

Selon l'invention, la forte inductance L des poutres anode 6 et cathode 8 à la fréquence élevée de travail de la diode est compensée par une capacité série intégrée à l'une ou aux deux poutres beam-lead.

Cette capacité est réalisée en ménageant une fente 10 sur toute l'épaisseur $e$ (figure 3) et sur toute la largeur $l$ (figure 1 ou 2) de la poutre anode 6 par exemple. Pour des raisons de commodité, cette fente est pratiquée sensiblement au milieu de la surface du berceau de verre 5 qui supporte la poutre 6. Ainsi, cette capacité représentée symboliquement en $C_S$ sur la figure 3, a comme première et seconde armatures la poutre fendue ou interrompue 6 et le berceau de verre 5 comme diélectrique.

On notera que la capacité peut également être intégrée dans la poutre cathode, ou encore dans chacune des poutres anode et cathode, sans sortir du cadre de l'invention.

Du point de vue technologique, cette capacité est réalisée lors de la métallisation de la poutre soit par photogravure soit par une technique de lift-off sur le verre qui sert de support et de diélectrique.

Pour compenser l'inductance donnée des poutres, la capacité $C_S$ est définie de manière à obtenir la résonance série, ou du moins s'en rapprocher le plus possible, avec l'inductance L des poutres à la fréquence de travail, c'est-à-dire d'avoir: $LC_S \omega^2 = 1$. A cet effet, la capacité est formée en fonction des dimensions de la fente 10 dans la poutre, notamment de sa largeur $\underline{d}$ et de sa longueur.

Ainsi, selon un mode de réalisation représenté sur la figure 1, la fente 10 est rectiligne avec une largeur $\underline{d}$ et une longueur égale à $\underline{l}$ qui sont définies en fonction de la capacité à obtenir.

Selon une variante représentée sur la figure 2, la fente 10 se présente sous forme d'une ligne à méandres délimitant des doigts métalliques parallèles 6a, 6b ... imbriqués les uns entre les autres, de même longueur par exemple, et dont le nombre et la distance $\underline{d}$ les séparant sont définis en fonction de la capacité à obtenir.

On a représenté sur les figures 4a et 4b la capacité $C_S$ ainsi formée en série avec l'inductance L, avec $LC_S \omega^2 = 1$, qui est introduite dans le schéma équivalent de la diode en polarisation inverse (figure 4a) et en polarisation directe (figure 4b).

La figure 5, qui reprend la structure de la diode PIN décrite précédemment à propos de la figure 3, met en évidence le fait que, dans le cas où la capacité formée $C_S$ est trop forte pour assurer la compensation de l'inductance des poutres, cette capacité est réglée ou ajustée en la diminuant en creusant une ouverture 12 de profondeur donnée dans le berceau de verre 5 par attaque chimique réalisée par la fente 10.

A l'opposé, sur la figure 6, en partant d'une capacité formée $C_S$ trop faible, celle-ci peut être augmentée en déposant une goutte 14 de matériau diélectrique sur la poutre anode 6 en comblant sa fente 10. La quantité de diélectrique déposé est telle qu'elle ajuste la capacité $C_S$ à la valeur assurant la compensation de l'inductance des poutres. De préférence, le diélectrique utilisé est un matériau polymérisable, tel que par exemple du polyimide chargé.

On notera que dans le cas où le creusement dans le berceau de verre 5, selon la figure 5, est réalisé trop profondément, donnant ainsi une capacité désormais trop faible, il est encore possible de régler correctement celle-ci en l'augmentant par un dépôt de diélectrique approprié dans l'ouverture du berceau de verre.

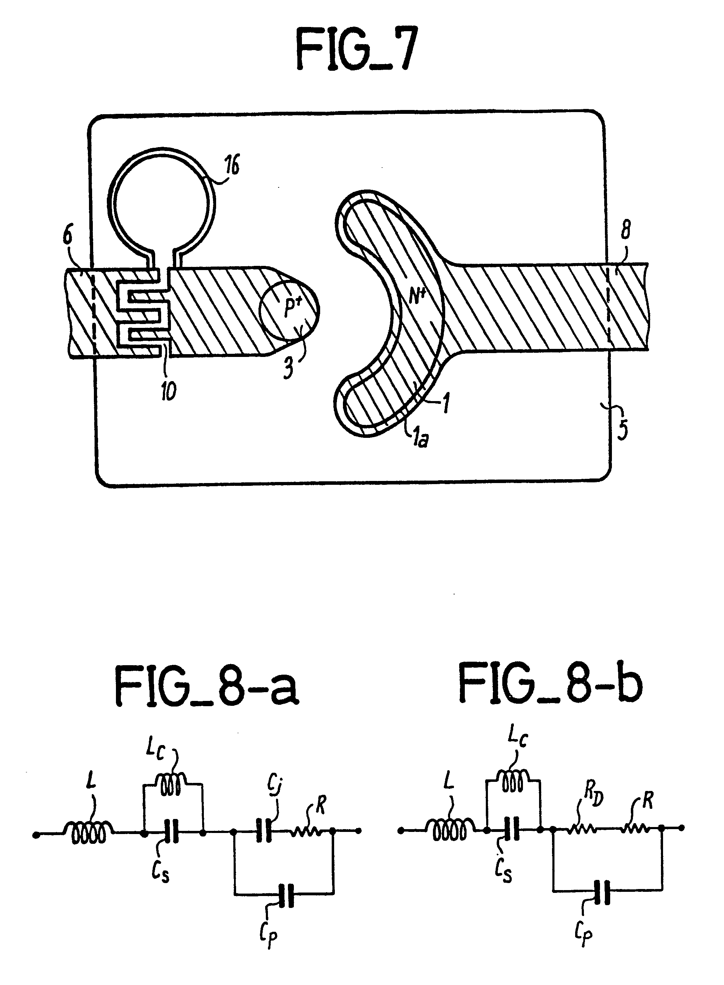

Sur la figure 7, qui reprend la structure de la diode PIN illustré sur la figure 2, on a représenté en 16 la connexion de polarisation de la diode qui est constituée par exemple par un fil fin métallique dont les extrémités sont fixées, par exemple par thermocompression, sur la poutre anode 6 de part et l'autre de sa fente 10. Ainsi, ce fil joue le rôle d'inductance dite de choc, c'est-à-dire à haute impédance, disposée en parallèle sur la capacité intégrée à la poutre anode, et dont la valeur est sensiblement proportionnelle à la longueur du fil.

De préférence, dans le domaine millimétrique, la connexion 16 de polarisation de la diode est constituée par une bande métallisée soit par photogravure soit par une technique de lift-off sur le berceau de verre 5, cette métallisation jouant également le rôle d'une inductance de choc en parallèle sur la capacité.

On notera que cette inductance formée par la connexion 16 peut également être réalisée sur la structure de la diode PIN telle qu'illustrée sur la figure 1.

On a représenté sur les figures 8a et 8b le schéma équivalent de la diode respectivement en polarisation inverse et en polarisation directe avec la présence de l'inductance de choc $L_C$, de valeur donnée très supérieure à celle de l'inductance L, de l'ordre de dix fois par exemple, en parallèle sur la capacité $C_S$ intégrée à la poutre.

On notera que la description ci-dessus a été faite en référence à une diode de type PIN dont le matériau de base était du silicium. Bien sûr, l'invention s'applique également pour tout autre type de diode, Schottky par exemple pour laquelle la couche 3 est en métal approprié, ainsi que pour un matériau de base de la famille III-V, GaAs par exemple.

D'autre part, bien que l'invention ait été décrite en s'appuyant sur le cas d'une diode, il est évident que son application à un dispositif plus complexe tel qu'un transistor doté de trois connexions externes sous forme de poutres à plat beam-lead entre également dans le domaine de l'invention.

**Revendications**

1. Dispositif semiconducteur hyperfréquence comportant une pastille semiconductrice sur laquelle sont fixée à plat au moins deux connexions externes (6, 8) prises au moyen de poutres métalliques, la pastille semiconductrice comprenant au moins deux couches (2, 3) supportées par un substrat (1), et un berceau (5) rempli d'un matériau diélectrique formant un cadre qui entoure la pastille semiconductrice, et sur lequel s'appuient à plat les poutres métalliques qui se terminent en porte-à-faux, les poutres introduisant une inductance parasite à la fréquence de travail en série avec la pastille semiconductrice, caractérisé en ce qu'au moins l'une (6) des poutres métalliques présente une fente (10) ménagée sur toute sa largeur et sur toute son épaisseur au niveau du matériau diélectrique supportant la poutre de façon à former une capacité en série avec l'inductance introduite par les poutres, et en ce que la fente (10) a des dimensions telles que la capacité formée réalise une résonance série avec l'inductance des poutres à la fréquence de travail, la capacité compensant ainsi l'inductance des poutres.

2. Dispositif semiconducteur selon la revendication 1, caractérisé en ce que la fente (10) est rectiligne avec une largeur déterminée de telle sorte que la valeur de la capacité formée compense celle de l'inductance des poutres.

3. Dispositif semiconducteur selon la revendication 1, caractérisé en ce que la fente (10) se présente sous forme d'une ligne à méandres avec une largeur et un nombre de méandres déterminés de telle sorte que la valeur de la capacité formée compense celle de l'inductance des poutres.

4. Dispositif semiconducteur selon l'une des revendications 1 à 3, caractérisé en ce que, avec une capacité trop forte formée par la poutre métallique fendue pour pouvoir compenser l'inductance des poutres à la fréquence de travail, la capacité est ajustée en la diminuant au moyen d'une ouverture (12) creusée dans le matériau diélectrique (5) au niveau de la fente (10) dans la poutre métallique.

5. Dispositif semiconducteur selon l'une des revendications 1 à 3, caractérisé en ce que, avec une capacité trop faible formée par la poutre métallique fendue pour pouvoir compenser l'inductance des poutres à la fréquence de travail, la capacité est ajustée en l'augmentant au moyen d'un dépôt de matériau diélectrique (14) de constante diélectrique donnée sur la poutre métallique fendue en comblant sa fente (10).

6. Dispositif semiconducteur selon la revendication 5, caractérisé en ce que le matériau diélectrique (14) est du polyimide chargé.

7. Dispositif semiconducteur selon l'une des revendications précédentes, caractérisé en ce qu'il comporte une connexion (16) de polarisation constituée par un fil métallique ou une bande métallique gravée dont les extrémités sont reliées à la poutre métallique fendue (6) et de part et d'autre de sa fente (10), formant ainsi une inductance en parallèle sur la capacité.

8. Dispositif semiconducteur selon l'une des revendications précédentes, caractérisé en ce que les couches (2, 3) de la pastille semiconductrice sont superposées et recouvrent partiellement la face avant (1a) du substrat, en ce que ses couches forment un îlot délimité par le berceau (5) qui s'étend dans le substrat (1) sur une profondeur donnée, et en ce que le berceau (5) est réalisé de façon à délimiter sous forme de croissant la partie de la face avant non recouverte du substrat, l'une (6) des poutres s'appuyant à plat sur l'îlot et l'autre poutre (8) s'appuyant à plat sur la face avant du substrat en épousant sa forme en croissant.

## Patentansprüche

1. Mikrowellen-Halbleiteranordnung mit einem Halbleiterchip, auf dem mindestens zwei aus metallischen Balken gebildete Aussenanschlüsse (6, 8) flach befestigt sind und das mindestens zwei von einem Substrat (1) getragene Schichten (2, 3) und eine mit einem dielektrischen Material gefüllte Mulde (5) aufweist, die einen das Halbleiterchip umgebenden Rahmen bildet, wobei die metallischen Balken sich flach auf diesem Rahmen abstützen und frei darüberhinausstehend enden und eine Störinduktivität in Reihe mit dem Halbleiterchip bei der Arbeitsfrequenz einführen, dadurch gekennzeichnet, dass mindestens einer der metallischen Balken (6) einen Spalt (10) aufweist, der über die ganze Breite und Dicke in Höhe des den Balken tragenden dielektrischen Materials ausgebildet ist, so dass er eine Kapazität in Reihe mit der von den Balken eingeführten Induktivität bildet, und dass der Spalt (10) solche Abmessungen hat, dass die gebildete Kapazität eine Serienresonanz mit der Induktivität der Balken bei der Arbeitsfrequenz bildet und somit die Induktivität der Balken kompensiert.

2. Halbleiteranordnung nach Anspruch 1, dadurch gekennzeichnet, dass der Spalt (10) geradlinig ist und eine Breite besitzt, die so bestimmt ist, dass der Wert der gebildeten Kapazität den der Induktivität der Balken kompensiert.

3. Halbleiteranordnung nach Anspruch 1, dadurch gekennzeichnet, dass der Spalt (10) mäanderförmig verläuft, mit einer Breite und einer Anzahl von Mäanderlinien, die so vorbestimmt sind, dass der Wert der gebildeten Kapazität den der Induktivität der Balken kompensiert.

4. Halbleiteranordnung nach einem der Ansprüche 1 bis 3, dadurch gekennzeichnet, dass bei einer zu grossen Kapazität, die vom metallischen gespaltenen Balken gebildet wird, um die Induktivität der Balken bei der Arbeitsfrequenz zu kompensieren, die Kapazität mithilfe einer in das dielektrische Material (5) in Höhe des Spalts (10) des metallischen Balkens eingeschnittenen Öffnung verringert wird.

5. Halbleitervorrichtung nach einem der Ansprüche 1 bis 3, dadurch gekennzeichnet, dass bei einer zu niedrigen von dem gespaltenen metallischen Balken gebildeten Kapazität, um die Induktivität der Balken bei der Arbeitsfrequenz kompensieren zu können, die Kapazität durch Aufbringen von dielektrischem Material (14) einer gegebenen Dielektrizitätskonstante auf den gespaltenen metallischen Balken vergrössert wird, indem sein Spalt (10) gefüllt wird.

6. Halbleiteranordnung nach Anspruch 5, dadurch gekennzeichnet, dass das dielektrische Material (14) geladenes Polyimid ist.

7. Halbleiteranordnung nach einem der vorhergehenden Ansprüche, dadurch gekennzeichnet, dass sie eine Polarisationsverbindung (16) bestehend aus einem Metalldraht oder einem gravierten Metallband aufweist, deren Enden an den gespaltenen metallischen Balken (6) zu beiden Seiten seines Spalts (10) angeschlossen sind und die so eine zur Kapazität parallele Induktivität bildet.

8. Halbleiteranordnung nach einem der vorhergehenden Ansprüche, dadurch gekennzeichnet, dass die Schichten (2, 3) des Halbleiterchips übereinanderliegen und teilweise die Vorderseite (1a) des Substrats bedecken, dass diese Schichten eine durch die Mulde (5), die sich in den Substrat (1) über eine gegebene Tiefe erstreckt, begrenzte Insel bilden und dass die Mulde (5) so ausgebildet ist, dass der nicht bedeckte Teil der Vorderseite des Substrats mondsichelförmig begrenzt wird, wobei einer der Balken (6) sich flach auf der Insel abstützt und der andere (8) sich flach auf der Vorderseite des Substrats abstützt, indem er sich der Mondsichelform anpasst.

## Claims

1. A microwave semiconductor device comprising a semiconducting chip on which at least two outside connections (6, 8) made of metal strips are flatly fixed, the semiconducting chip comprising at least two layers (2, 3) supported by a substrate (1), and a trough (5) filled with a dieletric material and constituting a frame surrounding the semiconductor chip, the metal strips being applied to this dieletric material and extending there-beyond, the strips introducing a parasite inductance at the working frequency in series with the semiconductor chip, characterized in that at least one of the metal strips (6) presents a slot (10) extending over its entire width and over its entire thickness at the level of the dieletric material supporting the strip such that a capacitance in series with the inductance produced by the strips is built, and that the slot (10) has such dimensions that the capacitance thus formed realises a series resonance with the inductance of the strips at the working frequency, the capacitance compensating the inductance of the strips.

2. A semiconductor device according to claim 1, characterized in that the slot (10) is rectilinear and has a width which is predetermined such that the value of the capacitance thus formed compensates the inductance of the strips.

3. A semiconductor device according to claim 1, characterized in that the slot (10) has the shape of a greek thread, the width and the number of meander lines being determined such that the value of the capacitance thus formed compensates the inductance of the strips.

4. A semiconductor device according to one of claims 1 to 3, characterized in that, the capacitance having been built too high by the split metal strip for being able to compensate the inductance of the strips at the working frequency, the capacitance is adjusted, i.e. reduced, by means of an opening (12) cut into the dieletric material (5) at the level of the slot (10) in the metal strip.

5. A semiconductor device according to one of claims 1 to 3, characterized in that, the capacitance having been built too low by the split metal strip for being able to compensate for the inductance of the strips at the working frequency, the capacitance is adjusted, i.e. increased, by depositing a dieletric material (14) of a given dielectricity constant on the split metal strip by filling its slot (10).

6. A semiconductor device according to claim 5, characterized in that the dieletric material (14) is a charged polyimid material.

7. A semiconductor device according to one of the preceding claims, characterized in that it comprises a polarisation connection (16) constituted by a metal wire or an engraved metal strip, the ends of which are connected to the split metal strip (6) on either side of the slot (10) thus constituting an inductance in parallel to the capacitance.

8. A semiconductor device according to one of the preceding claims, characterized in that the layers (2, 3) of the semiconductor chip are superimposed and partially cover the front face (1a) of the substrate, that these layers constitute an island which is delimited by the trough (5) which extends into the substrate (1) for a given depth, and that the trough (5) is realised such that it delimits in the shape of a sickle the portion of the substrate front face which is not covered, one of the strips (6) being flatly applied to the island and the other (8) being flatly applied to the front face of the substrate by accomodating its sickle shape.

# FIG_1

# FIG_2

# FIG_3

# FIG_4-a

# FIG_4-b

# FIG_5

# FIG_6

# FIG_7

# FIG_8-a    FIG_8-b